# DEMANDE DE BREVET EUROPEEN

(11) **EP 4 598 288 A1**
(43) Date de publication de la demande: **06.08.2025**
(21) Numéro de dépôt: 25154952.3
(22) Date de dépôt: 30.01.2025
(51) Int. Cl.: H05K 5/00

(54) **SUPPORT DE BOÎTIERS ÉLECTRONIQUES POUR COMPARTIMENT AUTOMOBILE DÉFORMABLE**

(30) Priorité: 02.02.2024 FR 2401036
(71) Demandeur: Renault s.a.s, 92100 Boulogne Billancourt (FR)
(72) Inventeur: PAROLINI, Pascal, 78280 Guyancourt (FR); WISS, Nicolas, 78280 GUYANCOURT (FR)

(57) **Abrégé**

Support (1) pour un boîtier électronique (2) destiné à équiper un compartiment déformable d'un véhicule, le support étant formé d'une pièce unique configurée pour être montée directement sur un élément structurel (3) du compartiment et comprenant un premier élément de fixation (15, 16) pour fixer le boîtier électronique au support, le support comprenant une plaque (5) formant protection mécanique du boîtier électronique et comprenant un élément de positionnement (8, 9, 10) relié à la plaque par une première extrémité et s'étendant en direction du boîtier électronique lorsqu'il est monté sur le support, l'élément de positionnement comprenant une seconde extrémité, la seconde extrémité étant pourvue d'un second élément de fixation (17, 18, 20) pour fixer le support à l'élément structurel, l'élément de positionnement protégeant le boîtier électronique entre la plaque formant protection mécanique et l'élément structurel lorsque le boîtier électronique est monté sur le support.

## Description

### Domaine technique

L'invention concerne un support d'un ou plusieurs boîtiers électroniques pour un compartiment déformable d'un véhicule automobile.

### Techniques antérieures

Il existe des calculateurs, en particulier des calculateurs utilisés pour la gestion électrique d'un véhicule automobile ou la gestion d'une boîte de vitesses, qui sont placés, sous forme d'un ou plusieurs boîtiers électroniques, dans un compartiment déformable du véhicule, par exemple sous le capot du véhicule. Un compartiment déformable est ici un compartiment conçu pour se déformer en cas de choc ou de crash afin d'absorber une partie de l'énergie du choc ou du crash et limiter ses effets sur l'habitacle et/ou sur les personnes situées à l'intérieur de celui-ci.

La détérioration ou la destruction de tels boîtiers électroniques lors d'un choc ou d'un crash ne pose généralement pas de problèmes particuliers, car ils n'ont pas de rôles particuliers lors du choc ou du crash, ni après. Il n'est donc pas nécessaire de les protéger et les supports utilisés pour fixer ces boîtiers électroniques à l'intérieur du compartiment déformable du véhicule automobile sont aussi simples que possible pour, notamment, contenir le nombre de pièces manipulées lors de la fabrication de véhicules automobiles et faciliter le montage et le démontage de ces boitiers électroniques, afin de limiter les coûts d'installation et de maintenance. De tels supports sont généralement montés sur un élément structurel du compartiment déformable, par exemple, sur un élément de renfort tel qu'un renfort côté auvent (aussi connu sous le nom de RCA).

Cependant, il existe d'autres calculateurs qui, lorsqu'ils sont placés dans un compartiment déformable d'un véhicule automobile, doivent être protégés. A titre d'illustration, un calculateur utilisé pour gérer l'injection de gaz de pétrole liquéfié (GPL) doit être protégé pour permettre, lors d'un choc ou d'un crash, de stopper l'alimentation du moteur en GPL.

Il existe des solutions pour protéger de tels boîtiers électroniques. En particulier, il existe des cloches configurées pour venir se fixer, de façon fixe ou mobile, aux supports de calculateurs et protéger ces derniers dans des cavités formées entre les supports et les cloches.

Bien que de telles solutions donnent généralement satisfaction en termes de protection mécanique, elles présentent néanmoins des inconvénients, notamment en termes de logistiques, d'installation, de maintenance et de coûts.

### Exposé de l'invention

Le but de l'invention est de proposer un support pour au moins un boîtier électronique équipant un compartiment automobile déformable, le support étant simple et économique à fabriquer, à monter et à démonter.

L'invention concerne ainsi un support pour au moins un boîtier électronique destiné à équiper un compartiment déformable d'un véhicule, le support étant formé d'une pièce unique configurée pour être montée directement sur un élément structurel du compartiment et comprenant un premier élément de fixation pour fixer l'au moins un boîtier électronique au support, le support comprenant une plaque formant protection mécanique de l'au moins un boîtier électronique et comprenant au moins un élément de positionnement relié à ladite plaque par une première extrémité et s'étendant en direction de l'au moins un boîtier électronique lorsqu'il est monté sur le support, l'au moins un élément de positionnement comprenant une seconde extrémité, la seconde extrémité étant pourvue d'un second élément de fixation pour fixer le support à l'élément structurel, l'au moins un élément de positionnement étant configuré pour protéger l'au moins un boîtier électronique entre la plaque formant protection mécanique et l'élément structurel lorsque l'au moins un boîtier électronique est monté sur le support.

Le support selon l'invention permet de limiter le nombre de pièces nécessaires au montage et à la protection mécanique de boîtiers électroniques dans un compartiment déformable d'un véhicule. Il est léger, simple et économique à fabriquer, à monter et à démonter.

Selon une caractéristique, une partie de l'au moins un élément de positionnement, s'étendant en direction de l'au moins un boîtier électronique lorsqu'il est monté sur le support, est plane et comprend une nervure de renfort. Une telle caractéristique permet notamment d'améliorer la protection des boîtiers électroniques.

Selon une autre caractéristique, la partie de l'au moins un élément de positionnement, s'étendant en direction de l'au moins un boîtier électronique lorsqu'il est monté sur le support, est partiellement évidée. Une telle caractéristique permet notamment d'alléger le support et de réduire la quantité de matière nécessaire à la fabrication du support.

Selon une autre caractéristique encore, la partie de l'au moins un élément de positionnement, s'étendant en direction de l'au moins un boîtier électronique lorsqu'il est monté sur le support, est sensiblement perpendiculaire à la plaque formant protection mécanique.

Selon une autre caractéristique, la seconde extrémité de l'au moins un élément de positionnement comprend une patte de fixation sensiblement perpendiculaire à la partie de l'au moins un élément de positionnement, s'étendant en direction de l'au moins un boîtier électronique lorsqu'il est monté sur le support.

Selon une autre caractéristique encore, le support comprend une pluralité d'éléments de positionnement de formes différentes.

Selon une autre caractéristique encore, le support comprend une pluralité d'éléments de positionnement, au moins deux éléments de positionnement étant disposés sur des bords opposés de la plaque formant protection mécanique. Une telle caractéristique permet notamment d'améliorer la protection des boîtiers électroniques.

Selon une autre caractéristique, la plaque formant protection mécanique est partiellement évidée. Une telle caractéristique permet notamment d'alléger le support et de réduire la quantité de matière nécessaire à la fabrication du support.

Selon un autre aspect, l'invention a pour objet un ensemble comprenant un support tel que défini précédemment et un boîtier électronique monté sur le support.

L'ensemble selon l'invention permet un montage et un démontage simple et économique, dans un compartiment déformable d'un véhicule, de boîtiers électroniques devant être protégés mécaniquement en cas de choc ou de crash.

Toujours selon un autre aspect, l'invention a pour objet un véhicule automobile équipé d'un ensemble comprenant un support tel que défini précédemment sur lequel est monté au moins un boîtier électronique.

### Brève description des dessins

D'autres buts, caractéristiques et avantages de l'invention apparaîtront à la lecture de la description suivante, donnée uniquement à titre d'exemple non limitatif, et faite en référence aux dessins annexés dans lesquels :
[Fig 1] représente une vue en perspective d'une portion d'un compartiment déformable d'un véhicule automobile, comprenant un support selon l'invention;
[Fig 2] illustre une vue en perspective du support de la [Fig 1] ; et
[Fig 3] illustre une vue en coupe du support de la [Fig 1] monté dans un compartiment déformable d'un véhicule automobile.

### Exposé détaillé d'au moins un mode de réalisation

On trouvera ci-après une description détaillée de modes de réalisation particuliers de l'invention, en se référant aux dessins dans lesquels les mêmes références identifient les mêmes éléments de structure dans chacune des figures.

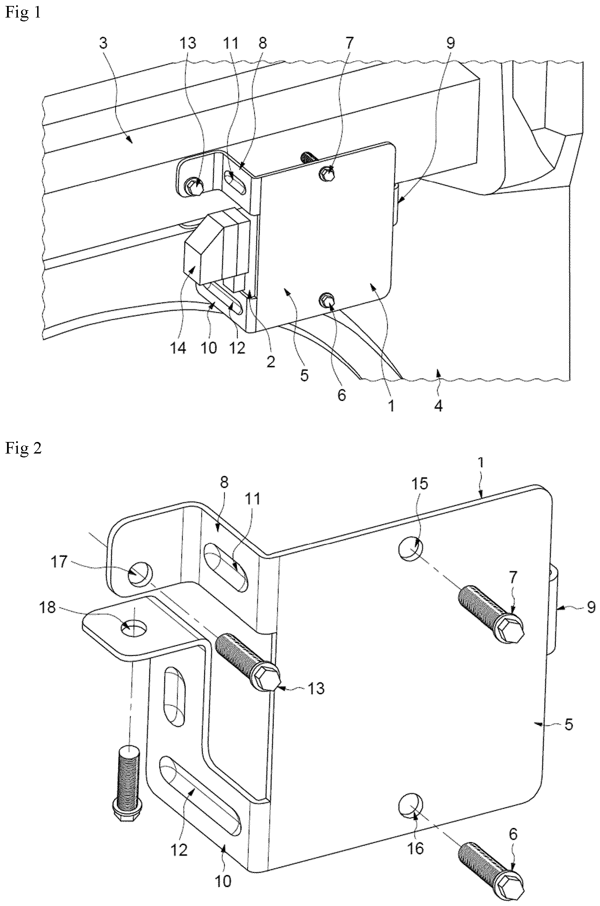

La figure 1 représente une vue en perspective d'une portion d'un compartiment déformable d'un véhicule automobile située, par exemple, sous le capot du véhicule. A titre d'illustration, la portion représentée est ici située sur le côté avant droit du véhicule, à proximité d'un passage de roue. Dans le mode de réalisation illustré, la portion du compartiment déformable du véhicule automobile comprend un support 1 pour un boîtier électronique 2 qui doit être protégé lors d'un choc latéral ou d'un crash. Le boîtier électronique 2 est par exemple un calculateur d'injection de GPL, qui est configuré pour stopper l'injection de GPL dans le moteur en cas de choc latéral ou de crash.

Comme illustré, le support 1 est fixé à un élément structurel du compartiment déformable, ici un renfort côté auvent 3 lui-même fixé à une aile 4 et à d'autres éléments structurels du véhicule. Selon des modes de réalisation, le support 1 consiste en une pièce unique réalisée par exemple en plastique, en acier ou en aluminium. Le support 1 comprend notamment une plaque 5, pleine ou partiellement évidée, par exemple sensiblement plane, ainsi qu'un élément de fixation du boîtier électronique 2, tel qu'une ou plusieurs pattes de maintien ou un évidemment configuré pour coopérer avec un moyen de fixation tel qu'un boulon, un rivet ou tout autre moyen similaire. Selon l'exemple illustré, la plaque 5 comprend deux trous (visibles sur la figure 2) pouvant recevoir des boulons ou des rivets 6 et 7 permettant de fixer le boîtier électronique 2 au support 1.

Le support 1 comprend en outre un ou plusieurs éléments de positionnement, par exemple trois éléments de positionnement 8, 9 et 10. Le ou les éléments de positionnement permettent de positionner de façon précise le support, et donc le ou les boîtiers électroniques, par rapport à l'élément structurel 3 auquel est fixé le support. Ils s'étendent, à partir de la plaque 5, dans la direction du boîtier électronique, par exemple de façon sensiblement perpendiculaire à la plaque 5. Ils jouent également un rôle d'entretoise pour former une cavité entre la plaque 5 et l'élément structurel 3 et/ou entre la plaque 5 et un ou plusieurs autres éléments reliés directement ou indirectement à l'élément structurel 3, par exemple l'aile 4. Cette cavité est configurée pour accueillir le boîtier électronique 2.

Selon des modes de réalisation particuliers, au moins deux éléments de positionnement sont montés sur des bords opposés de la plaque 5 pour améliorer la résistance au déplacement de la plaque 5 en cas de choc ou de crash. Deux éléments de positionnement peuvent également montés aux extrémités opposées d'un même bord de la plaque 5 pour améliorer sa stabilité en cas de choc ou de crash.

Toujours selon des modes de réalisation particuliers, un, plusieurs ou tous les éléments de positionnement peuvent comprendre une ou plusieurs nervures de renfort, par exemple obtenue par emboutissage, pour rigidifier les éléments de positionnement 8, 9 et 10 et, ainsi, améliorer la protection mécanique boîtier électronique 2. Selon l'exemple illustré, les éléments de positionnement 8 et 10 comprennent les nervures de renfort 11 et 12, respectivement.

Les éléments de positionnement comprennent une première extrémité reliée à la plaque 5 et une deuxième extrémité comprenant un ou plusieurs éléments de fixation, permettant la fixation du support 1 à l'élément structurel 3. Par exemple, la deuxième extrémité des éléments de positionnement 8 et 10 comprend un évidemment (visibles sur la figure 2) configuré pour coopérer avec un moyen de fixation tel qu'un boulon, un rivet ou tout autre moyen similaire. Selon l'exemple illustré, la deuxième extrémité de l'élément de positionnement 8 comprend un trou pouvant recevoir un boulon ou un rivet 13 permettant de fixer le support 1 à l'élément structurel 3.

Il est observé ici que les éléments de positionnement peuvent avoir des formes identiques ou différentes. Ils peuvent être pleins ou partiellement évidés, par exemple pour alléger le support et/ou permettre le passage d'éléments tels qu'un connecteur 14 reliant le boîtier électronique 2 à des éléments électriques et/ou électroniques distants, par exemple des capteurs, des actionneurs, une source électrique, etc. Les éléments de positionnement peuvent comprendre une partie telle qu'une partie sensiblement plane jouant le rôle d'entretoise, par exemple une partie sensiblement perpendiculaire à la plaque 5 de protection mécanique. Les éléments de positionnement peuvent également fournir une fonction de protection mécanique du boîtier électronique. La deuxième extrémité peut prendre la forme d'une patte pourvue d'un trou configuré pour recevoir un moyen de fixation tel qu'un boulon, un rivet ou tout autre moyen similaire. Selon des modes de réalisation particuliers, la patte est sensiblement perpendiculaire à la partie jouant le rôle d'entretoise.

Il est également observé ici que selon d'autres modes de réalisation, le ou les boîtiers électroniques sont fixés à un ou plusieurs éléments de positionnement ou à la plaque et à un ou plusieurs éléments de positionnement.

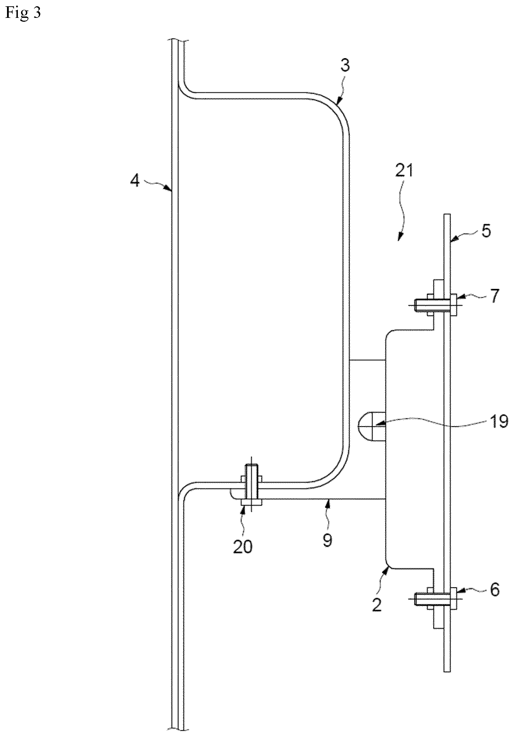

La figure 2 est une vue en perspective du support 1 de la figure 1, sans le boîtier électronique 2 et non monté sur un élément structurel d'un compartiment déformable d'un véhicule automobile. Comme illustré, le support 1 comprend ici deux trous 15 et 16 configurés pour fixer le boîtier électronique 2 au support 1 à l'aide de boulons (par exemple les boulons 6 et 7), de rivets ou de tout autre moyen similaire. Il comprend également trois trous dont seuls les trous 17 et 18 des éléments de positionnement 8 et 10 sont visibles, le trou de l'élément de positionnement 9 étant masqué par la plaque de protection 5 et l'élément de positionnement 9 lui-même. Les trous 17 et 18 et celui de l'élément de positionnement 9 (référencé 20 sur la figure 3) sont configurés pour fixer le support 1 à l'élément structurel 3 à l'aide de boulons (par exemple le boulon 6), de rivets ou de tout autre moyen similaire.

La figure 3 est une vue en coupe du support 1 de la figure 1, monté sur l'élément structurel 3 d'un compartiment déformable d'un véhicule automobile et comprenant le boîtier électronique 2, selon un plan perpendiculaire à la plaque 5 et passant par les centres axiaux des boulons 6 et 7.

Comme illustré, l'élément de positionnement 9 comprend ici une nervure de renfort 19 et, à l'extrémité opposée à celle le liant à la plaque 5, un trou permettant la fixation du support 1 à l'élément structurel 3 à l'aide d'un boulon 20, d'un rivet ou de tout autre moyen similaire.

Selon d'autres modes de réalisation, un ou plusieurs éléments de positionnement comprennent, à l'extrémité opposée à celle les liant à la plaque formant protection mécanique, un élément de liaison permettant un encliquetage du support sur un élément structurel, simplifiant la pose et le retrait du support sur l'élément structurel par une réduction du nombre de boulons ou de rivets nécessaire à sa fixation.

Comme illustré sur la figure 3, la fonction d'entretoise des éléments de positionnement 8, 9 et 10 permet de créer une cavité 21 entre la plaque 5 et l'élément structurel 3, dans lequel se trouve le boîtier électronique 2 qui est ainsi protégé mécaniquement.

Le support 1 peut être fabriqué par emboutissage d'une tôle, par exemple d'une tôle en acier ou en aluminium.

Selon des modes de réalisation particuliers, un ou plusieurs boîtiers électroniques tel que le boîtier électronique 2 sont montés sur un support tel que le support 1 à l'aide de boulons, de rivets et/ou de tout autre moyen similaire. Le support peut alors être monté sur un élément structurel d'un compartiment déformable d'un véhicule automobile, à l'aide de boulons, de rivets et/ou de tout autre moyen similaire et, le cas échéant, d'un mécanisme d'encliquetage. Inversement, pour démonter le ou les boîtiers électroniques, par exemple pour les remplacer, le support du ou des boîtiers électroniques est démonté puis les boîtiers électroniques sont désolidarisés du support.

Le support selon l'invention permet de réduire le nombre de pièces nécessaires à la mise en place d'un ou plusieurs boîtiers électroniques qui doivent être protégés mécaniquement et de simplifier les opérations de montage et de démontage de ces boîtiers électroniques. Le support illustré sur les figures 1 à 3 peut être monté dans tout type de véhicule.

## Revendications

1. Support (1) pour au moins un boîtier électronique (2) destiné à équiper un compartiment déformable d'un véhicule, le support étant formé d'une pièce unique configurée pour être montée directement sur un élément structurel (3) du compartiment et comprenant un premier élément de fixation (15, 16) pour fixer l'au moins un boîtier électronique (2) au support (1), **caractérisé en ce que** le support (1) comprend une plaque (5) formant protection mécanique de l'au moins un boîtier électronique (2) et comprend au moins un élément de positionnement (8, 9, 10) relié à ladite plaque (5) par une première extrémité et s'étendant en direction de l'au moins un boîtier électronique (2) lorsqu'il est monté sur le support (1), l'au moins un élément de positionnement (8, 9, 10) comprenant une seconde extrémité, la seconde extrémité étant pourvue d'un second élément de fixation (17, 18, 20) pour fixer le support (1) à l'élément structurel (3), l'au moins un élément de positionnement (8, 9, 10) étant configuré pour protéger l'au moins un boîtier électronique (2) entre la plaque (5) formant protection mécanique et l'élément structurel (3) lorsque l'au moins un boîtier électronique (2) est monté sur le support (1).

2. Support selon la revendication 1, dans lequel une partie de l'au moins un élément de positionnement (8, 9, 10), s'étendant en direction de l'au moins un boîtier électronique (2) lorsqu'il est monté sur le support (1), est plane et comprend une nervure de renfort (11, 12, 19).

3. Support selon la revendication 2, dans lequel la partie de l'au moins un élément de positionnement (8, 9, 10), s'étendant en direction de l'au moins un boîtier électronique (2) lorsqu'il est monté sur le support (1), est partiellement évidée.

4. Support selon la revendication 2 ou la revendication 3, dans lequel la partie de l'au moins un élément de positionnement (8, 9, 10), s'étendant en direction de l'au moins un boîtier électronique (2) lorsqu'il est monté sur le support (1), est sensiblement perpendiculaire à la plaque (5) formant protection mécanique.

5. Support selon l'une quelconque des revendications 2 à 4, dans lequel la seconde extrémité de l'au moins un élément de positionnement (8, 9, 10) comprend une patte de fixation sensiblement perpendiculaire à la partie de l'au moins un élément de positionnement (8, 9, 10), s'étendant en direction de l'au moins un boîtier électronique (2) lorsqu'il est monté sur le support (1).

6. Support selon l'une quelconque des revendications 1 à 5, le support (1) comprenant une pluralité d'éléments de positionnement de formes différentes.

7. Support selon l'une quelconque des revendications 1 à 6, le support (1) comprenant une pluralité d'éléments de positionnement, au moins deux éléments de positionnement étant disposés sur des bords opposés de la plaque (5) formant protection mécanique.

8. Support selon l'une quelconque des revendications 1 à 7, dans lequel la plaque (5) formant protection mécanique est partiellement évidée.

9. Ensemble comprenant le support (1) selon l'une quelconque des revendications 1 à 8 et comprenant le au moins un boîtier électronique (2) monté sur le support (1).

10. Véhicule automobile équipé d'un ensemble selon la revendication 9.
